(19) Europäisches Patentamt / European Patent Office / Office européen des brevets

(11) **EP 2 720 084 B1**

(12) **EUROPEAN PATENT SPECIFICATION**

(45) Date of publication and mention
of the grant of the patent:
**04.12.2019 Bulletin 2019/49**

(51) Int Cl.:
*G02B 3/14* (2006.01)  *H04N 5/225* (2006.01)
*G02F 1/1362* (2006.01)  *G02F 1/29* (2006.01)
*G02F 1/1345* (2006.01)  *G02F 1/13* (2006.01)

(21) Application number: **13188154.2**

(22) Date of filing: **10.10.2013**

(54) **Method of integrating circuits for a camera and a liquid crystal lens in a liquid crystal display panel and the liquid crystal display panel**

Verfahren zur Integration von Kamera-Schaltungen und einer Flüssigkristalllinse in eine Flüssigkristalldisplaytafel und die Flüssigkristalldisplaytafel

Procédé d'intégration de circuits pour une caméra et une lentille à cristaux liquides dans un panneau d'affichage à cristaux liquides et le panneau d'affichage à cristaux liquides

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.10.2012 CN 201210384120**

(43) Date of publication of application:
**16.04.2014 Bulletin 2014/16**

(73) Proprietor: **BOE Technology Group Co., Ltd.**
**Beijing 100015 (CN)**

(72) Inventors:
• **Li, Wenbo**
**100176 Beijing (CN)**
• **Wu, Yanbing**
**100176 Beijing (CN)**
• **Zhang, Mi**
**100176 Beijing (CN)**

(74) Representative: **Klunker IP**
**Patentanwälte PartG mbB**
**Destouchesstraße 68**
**80796 München (DE)**

(56) References cited:
WO-A1-85/05466    US-A1- 2001 000 676
US-A1- 2004 212 555    US-B1- 6 380 560

• **Ernst Lueder: "Liquid Crystal Displays", 2001, John Wiley & Sons, Ltd, UK, XP002719627, ISBN: 0 471 49029 6 pages 78-79, * page 78 - page 79 ***

**Description**

TECHNICAL FIELD

Embodiments of the present disclosure relates to a method for integrating a camera in a liquid crystal display panel, the liquid crystal display panel and a liquid-crystal display device.

BACKGROUND

Camera, also known as PC camera, PC eye, etc., is employed as a video input device and widely applied in the aspects of video conference, tele-medicine, real-time monitor or the like. In recent years, with the development of the internet technology, the continuous improvement of the internet speed and the mature of the technology of photosensitive imaging devices, communicating parties can chat and communicate with each other smoothly via video and voice on the internet through the cameras. Cameras play an increasingly important role in people's lives and work.

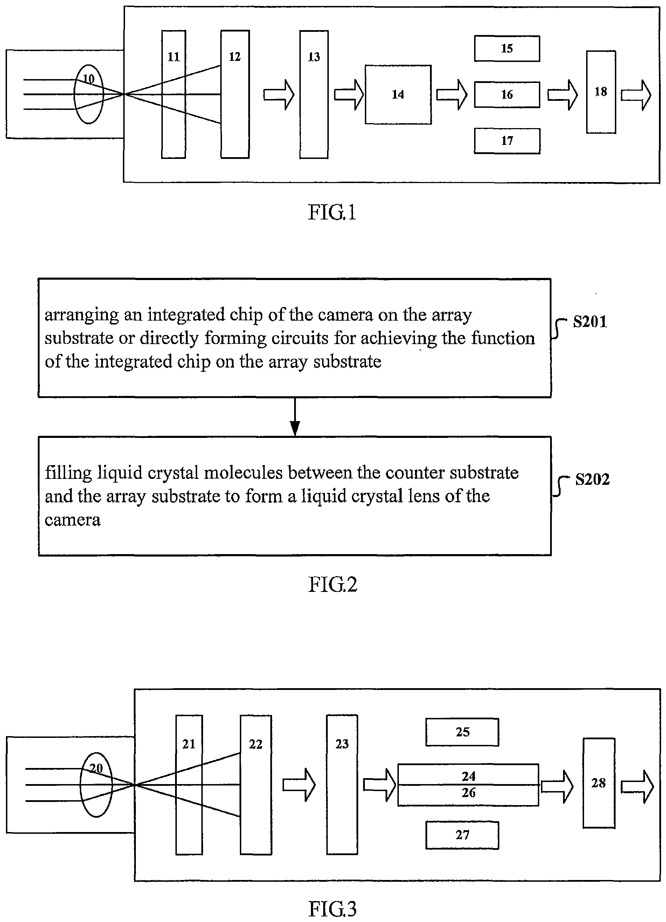

FIG 1 is a schematic structural view of a traditional camera. The camera comprises a lens 10, an optical filter 11, an image sensor 12, a digital signal processor (DSP) 13, a compression and encoding processor 14, and a power supply (not shown). The lens 10 may be an optical glass lens; external light is introduced from the lens 10 and subjected to color filtering through the optical filter 1. The image sensor 12 may be a charge coupled device (CCD) or a complementary metal oxide semiconductor (CMOS) device and is configured to convert optical signals, subjected to color filtering by the optical filter, into electrical signals. The DSP 13 is configured to optimize digital image signals. Two types of operating voltages, i.e., 3.3V and 2.5V, are required by the camera, and in addition, a good internal electric source of the camera can ensure the stable operation of the camera. An optical image of a scene formed from the lens 10 is projected on the surface of the image sensor 12 and converted into an electrical signals; the electrical signals are converted into digital image signals after subjected to analog-to-digital (A/D) conversion; and the digital image signals are hence sent into the DSP 13 for further processing, compressed by the compression and encoding processor 14, finally outputted into, for instance, a computer for storing or processing through an interface circuit, and presented to users through a display. Of course, the camera may further comprise a central processing unit (CPU) 16, a random access memory (RAM) 17, an FLASH memory (FLASH) 15, an interface 18 and other commonly used components.

At current camera technology has been widely applied in the fields of mobile phones, notebooks, and domestic and commercial televisions. A front camera is usually integrated on a frame around a liquid crystal panel. However, with the popularity of display screens with narrow frames or even without frames, the area of a display panel, adapted to arrange a camera, is reduced, or even there is no area for arranging the camera. Therefore, how to integrate a camera on a liquid crystal panel with a narrow frame or even without a frame has become one of the technical problems to be solved.

WO 85/05466 A1 discloses a variable power lens system with an optical lens which can be focused electronically without mechanical movement. There are no moving mechanical parts but instead an optically active molecular material such as liquid crystals. In one embodiment, the lens and control means for varying the power of the lens are mounted on a common substrate. The lens may be a single optical element or a multi-element device such as a Fresnel lens. A thin film embodiment finds applications in magnifying glasses, cameras, telescopes, microscopes, as well as for intraocular and contact lenses for the human eye.

US 2004/0212555 A1 discloses a portable electronic device with integrated display and camera and method therefore. The portable electronic device comprises a printed circuit board, a display having one or more display layers, and an integrated camera coupled between the one or more display layers and the printed circuit board, wherein the one or more display layers are constructed such that a light stream flows through to the integrated camera.

SUMMARY

It is an object of the present disclosure to provide a method for integrating a camera in a liquid crystal display panel, a liquid crystal display panel and a liquid-crystal display device, by which and in which, respectively, the camera on the liquid crystal panel is integrated with a narrow frame or without a frame.

In a first aspect, the present disclosure provides a method for integrating a camera on a liquid crystal panel according to claim 1.

A secon aspect, the present disclosure provides a liquid crystal panel according to claim 5.

Furthemore, the present disclosure provides a liquid-crystal display device, which comprises the foregoing liquid crystal panel.

Further scope of applicability of the present disclosure will become apparent from the detailed description given hereinafter.

BRIEF DESCRIPTION OF THE DRAWINGS

The present disclosure will become more fully understood from the detailed description given hereinafter and the accompanying drawings which are given by way of illustration only, and thus are not limitative of the present disclosure and wherein:

FIG 1 is a schematic structural view of a traditional camera;

FIG. 2 is a schematic diagram of a method for integrating a camera on a liquid crystal panel, provided by an embodiment of the present disclosure;

FIG. 3 is a schematic structural view of a camera, in which circuits configured to achieve the functions of a compression algorithm processor and a CPU respectively are integrated on a same chip, provided by an embodiment of the present disclosure;

FIG. 4 is a schematic structural view of a camera, in which circuits configured to achieve the functions of a compression algorithm processor, a CPU, an FLASH and a RAM respectively are integrated on a same chip, provided by an embodiment of the present disclosure;

FIG. 5 is a schematic structural view of a camera, in which circuits configured to achieve the functions of a compression algorithm processor, a CPU, an FLASH, a RAM and a DSP respectively are integrated on a same chip, provided by an embodiment of the present disclosure;

FIG. 6 is a schematic structural view of a camera, in which circuits configured to achieve the functions of a compression algorithm processor, a CPU, an FLASH, a RAM, a DSP and an image sensor respectively are integrated on a same chip, provided by an embodiment of the present disclosure;

FIG. 7 is a schematic diagram illustrating the imaging principle of a liquid crystal lens in an embodiment of the present disclosure;

FIG. 8 is a schematic diagram illustrating the refractive index distribution of the liquid crystal lens in an embodiment of the present disclosure;

FIG. 9 is a schematic diagram illustrating the definition of the polar angle of liquid crystal molecules in an embodiment of the present disclosure;

FIG. 10 is a schematic structural view of a liquid crystal panel provided by an embodiment of the present disclosure;

FIGs. 11a to 11d are schematic diagrams of four examples of the position of divided partial spaces in an embodiment of the present disclosure; and

FIG. 12 is a schematic structural view of a liquid crystal panel provided by an embodiment of the present disclosure.

DETAILED DESCRIPTION

In order to integrate a camera on a liquid crystal panel with a narrow frame or even without a frame, embodiments of the present disclosure provide a method for integrating a camera in a liquid crystal display panel, the liquid crystal display panel and a liquid crystal display device comprising the liquid crystal display panel.

FIG. 2 is a schematic diagram of the method for integrating a camera on a liquid crystal display panel, provided by an embodiment of the present disclosure. The liquid crystal display panel comprises an array substrate and a counter substrate, and a liquid crystal layer is disposed between the array substrate and the counter substrate; the counter substrate is, for instance, a color filter substrate. The method for integrating the camera on the liquid crystal display panel comprises the following process steps.

S201: arranging an integrated chip on the array substrate or directly forming circuits for achieving the function of the integrated chip on the array substrate.

The integrated chip may include an image sensor, a signal processing and acontrol device, and a memory device, and the image sensor may be a CCD or a CMOS.

For instance, the circuits configured to achieve the functions of any combination of a CPU, a RAM, an FLASH, a DSP, a compression and encoding processor, and the image sensor or to achieve the functions of all the devices are integrated into the integrated chip. A RAM and an FLASH are used for data storage and are examples of the memory device in the camera of an embodiment of the present disclosure. The present disclosure is not limited to the specific examples. In addition, a CPU, a DSP, and a compression and encoding processor are configured to process image signals acquired by the image sensor, and are examples of the signal processing and control device in the camera of an embodiment of the present disclosure. The present disclosure is not limited to the specific examples.

As for the foregoing examples, for instance, the circuits configured to achieve the functions of a CPU, a RAM, an FLASH, a DSP, a compression and encoding processor, and an image sensor respectively may be integrated on the integrated chip according to the following processes:

Firstly, forming the circuits configured to achieve the functions of a CPU, a RAM, an FLASH, a DSP, and a compression and encoding processor respectively on a same chip; and

secondly, integrating circuits for achieving the function of an image sensor on the chip, on which the circuits configured to achieve the functions of the CPU, the RAM, the FLASH, the DSP and the compression and encoding processor respectively are formed, by photolithography technology, so as to form the integrated chip.

As another example, firstly, the circuits configured to achieve the functions of the compression algorithm processor and the CPU may be respectively formed on the same chip. FIG 3 is a schematic structural view of the example of an integrated camera. The example of the camera includes a lens 20, an optical filter 21, an image sensor 22, a DSP 23, a compression and encoding processor 24, an FLASH 25, a CPU 26, an RAM 27, an interface 28 and other components, and the interface 28 is configured to connect the camera and an input circuit of another system (such as a computer or a display for employing captured images); and the lens 20 herein is a liquid crystal lens.

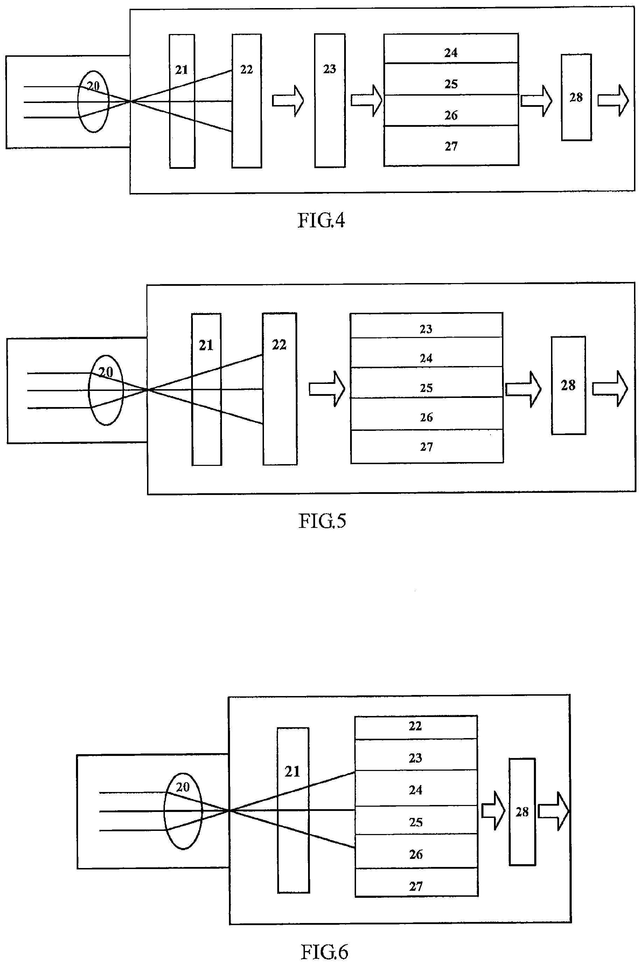

Further, for instance, the circuits configured to achieve the functions of the FLASH and the RAM are respectively formed on the chip. FIG. 4 is a schematic structural view of the example of the integrated camera.

Furthermore, for instance, the circuit for achieving the function of the DSP is formed on the chip. FIG. 5 is a schematic structural view of the example of the integrated camera.

Finally, for instance, the circuit for achieving the function of the image sensor is formed on the chip by compatible photolithography technology to obtain the integrated chip. FIG. 6 is a schematic structural view of an example of the integrated camera.

It should be noted that the sequence of the circuits, configured to achieve the functions of various modules, formed on the same chip respectively is not limited in the embodiment of the present disclosure. The forming sequence of the circuits can be determined based on actual conditions.

After the integrated chip is obtained, the integrated chip may be arranged on the array substrate by bonding for example.

Moreover, circuits for achieving the function of the integrated chip may be directly formed on the array substrate. In this way, the circuits configured to achieve the functions of various modules are not required for integration. For instance, as for the foregoing examples, the circuits configured to achieve the functions of the CPU, the RAM, the FLASH, the DSP, the compression and encoding processor and the image sensor can be respectively formed on the array substrate. It should be noted that direct forming of the circuits for achieving the function of the integrated chip on the array substrate may be completed synchronously with the manufacturing of the array substrate of the liquid crystal panel, by the photolithography processes including exposure and development.

The array substrate may be, but not limited to, a monocrystalline silicon array substrate, a low-temperature polysilicon array substrate, a high-temperature polysilicon array substrate, or any other array substrate in which the peripheral integrated circuits have high mobility.

S202: filling liquid crystal molecules between the counter substrate and the array substrate to form a liquid crystal lens.

For instance, liquid crystals may be filled between a color filter substrate and an array substrate through TFT-LCD technologies, so as to form a "planar" liquid crystal lens. The color filter substrate is an example of the counter substrate. The liquid crystal lens focuses or diverges light beams by utilization of the birefringent characteristic of the liquid crystal molecules and the characteristic of arrangement according to distribution of electric fields of the liquid crystal molecules, so as to achieve the functions of a traditional lens (e.g., a plastic or glass lens). The size of the liquid crystal lens can be set as required. The liquid crystal lens cooperates with the integrated chip disposed on the array substrate to form a camera. Hence, the camera in the embodiment of the present disclosure is integrated into the corresponding liquid crystal display panel.

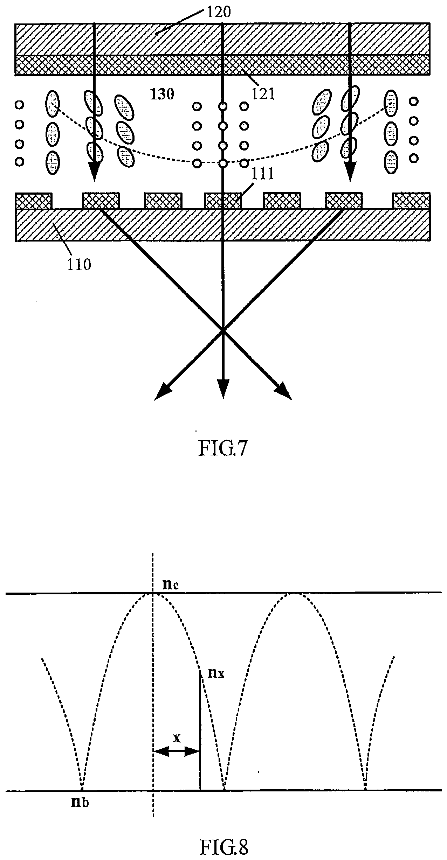

FIG. 7 is a schematic diagram illustrating the imaging principle of the liquid crystal lens. As illustrated in FIG. 7, the liquid crystal lens of the embodiment of the present disclosure comprises an array substrate 110, a counter substrate 120 and a liquid crystal layer 130 disposed between the array substrate 110 and the counter substrate 120. Pixel drive circuits, for instance, passive matrix drive circuits or active matrix drive circuits, more specifically, active matrix drive circuits employing thin film transistors (TFT) as switching elements, are arranged on the array substrate 110. Moreover, in order to form a liquid crystal lens, an electrode 111 is arranged on the array substrate 110; an electrode 121 is arranged on the counter substrate 120; when the operating voltage is applied across the electrode 111 and the electrode 121, an electric field is formed between the electrode 111 and the electrode 121 and configured to deflect the liquid crystal molecules in the liquid crystal layer 130; and drive circuits for the electrode 111 and the electrode 121 are achieved through TFT drive circuits in a general liquid crystal panel. The present disclosure is not limited to specific structures of the circuits as illustrated in FIG 7.

Compared with a traditional lens, the liquid crystal lens also has the following advantages that: the traditional lens can magnify a portion of photo through digital technology only to achieve the visual effect of "zooming" and cannot achieve real optical zoom, but the liquid crystal lens can change the arrangement direction of the liquid crystal molecules by the change of the applied operating voltage and hence achieve the effect of adjusting the physical focus. The light and thin characteristic of the liquid crystal lens is another great advantage, and the efficient optical zoom effect can be achieved in a small space; and all the traditional lenses are perceptible lenses and hence the position of a camera in the equipment is notable as well, which is unfavorable for the monitoring and protection of confidential information, but the "planar" liquid crystal lens formed by utilization of the characteristics of the liquid crystal molecules almost does not have any difference from the liquid crystal panel observed from the surface and thus has strong concealment.

FIG 8 is a schematic diagram illustrating the distribution of the refractive index of the liquid crystal lens, where $\Delta n \bullet D = \dfrac{x^2}{2f}$ and $\Delta n = n_c - n_x$. The definitions of various parameters are as follows: $\Delta n$ refers to the birefringence of liquid crystal molecules; $D$ refers to the thickness of the liquid crystal lens; $x$ refers to the distance with respect to the center of the lens; $f$ refers to the focus of the lens; $n_c$ refers to the refractive index of the center of the liquid crystal lens; $n_x$ refers to the refractive index of a position at distance $x$ from the center of the liquid crystal lens; $n_b$ refers to the refractive index of both ends of the liquid crystal lens; and the birefringence of the liquid crystal molecules is $\Delta n = n_{e\,eff} - n_o$. As for the liquid crystal molecules of the liquid crystal layer in the structure, for instance, as illustrated in FIG. 7, the effective refractive index of extraordinary light of the liquid crystal molecules satisfies the following formula:

$$n_{e\,eff} = \frac{n_o n_e}{\sqrt{n_o^2 \cos^2 \theta + n_e^2 \sin^2 \theta}},$$

where $n_{e\,eff}$ refers to the effective refractive index of the extraordinary light of the liquid crystal molecules; $n_e$ refers to the refractive index of the extraordinary light of the liquid crystal molecules; $n_0$ refers to a refractive index of ordinary light of the liquid crystal molecules;

and $\theta$ refers to the polar angle of the liquid crystal molecules.

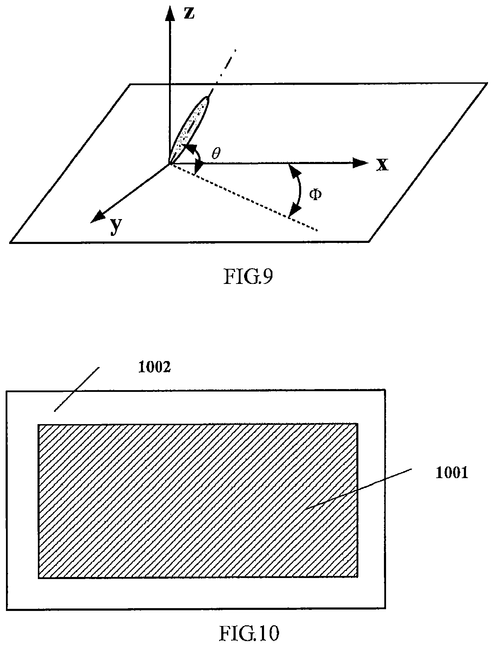

FIG 9 is a schematic diagram illustrating the definition of the polar angle of the liquid crystal molecules. Moreover, $\Phi$ refers to the azimuth of the liquid crystal molecules. The phase delay of the liquid crystal molecules is illustrated as follows:

$$\Delta nd = (n_{e\,eff} - n_o)d = (\frac{n_o n_e}{\sqrt{n_o^2 \cos^2 \theta + n_e^2 \sin^2 \theta}} - n_o)d,$$

Therefore, the birefringence of the liquid crystal molecules can be changed by the application of different voltages. As seen from the formula $\Delta n \bullet D = \dfrac{x^2}{2f}$, the focus of the liquid crystal lens can be adjusted through the adjustment on $\Delta n$.

For instance, in order to not affect the display effect of the liquid crystal display panel, the liquid crystal lens provided by the embodiment of the present disclosure is disposed at a non-effective display area of the liquid crystal panel. There are two ways to arrange the liquid crystal lens as follows.

First way: the liquid crystal lens is arranged at a peripheral circuit area of the liquid crystal display panel.

FIG. 10 is a schematic diagram of an example of the position relation between the liquid crystal lens and the liquid crystal display panel. The liquid crystal lens is disposed in the peripheral circuit area of the liquid crystal display panel, and drive circuits of the liquid crystal lens (namely the integrated chip) are integrated on the array substrate. The shadow area as illustrated in FIG. 10 is an effective display area 1001, and the peripheral blank area is a circuit area 1002.

Second way: a partial space is divided from the original effective display area of the liquid crystal panel and configured to arrange the liquid crystal lens.

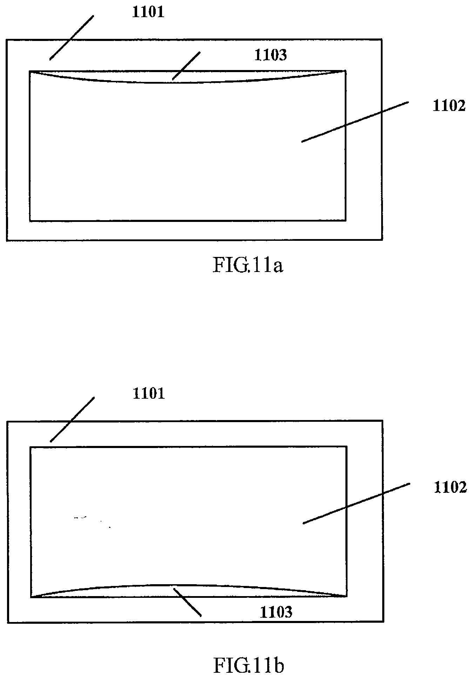

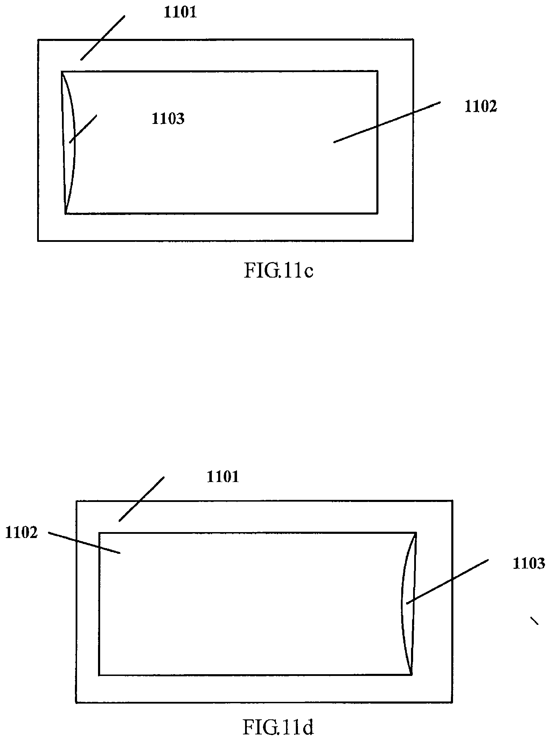

FIGS. 11a to 11d are schematic diagrams of examples of the position of the divided partial space. In the embodiment, the liquid crystal display panel comprises a peripheral circuit area 1101, an effective display area 1102, and a liquid crystal lens arrangement area 1103. In the example as illustrated in FIG. 11a, the liquid crystal lens arrangement area 1103 is disposed at the upper side of the effective display area 1102. In the example as illustrated in FIG. 11b, the liquid crystal lens arrangement area 1103 is disposed at the lower side of the effective display area 1102. In the example as illustrated in FIG. 11c, the liquid crystal lens arrangement area 1103 is disposed at the left side of the effective display area 1102. In the example as illustrated in FIG. 11d, the liquid crystal lens arrangement area 1103 is disposed at the right side of the effective display area 1102. It should be noted that: as the divided partial space configured to arrange the liquid crystal lens cannot be used for image display anymore, the selection principle is that the position of the liquid crystal lens does not affect the overall display effect of the liquid crystal panel. Therefore, the liquid crystal lens may be arranged on any of the four edges of the original effective display area, so as to reduce the impact on the display effect as much as possible.

In the embodiment of the present disclosure, the camera and relevant drive circuits (the integrated chip) are integrated or attached (e.g., bonded) on the liquid crystal panel by circuit integration process, without occupying the area of an outer frame. Meanwhile, the "planar" liquid crystal lens can achieve physical zooming and have stronger picture capturing capability.

Other embodiments of the present disclosure further provide a liquid crystal display panel and a liquid-crystal display device. As the operating principles of the devices are similar to those of the method for integrating the camera on the liquid crystal panel, the description of the devices can refer to the method for integrating the camera on the liquid crystal display panel, and the description will not be repeated for simplicity.

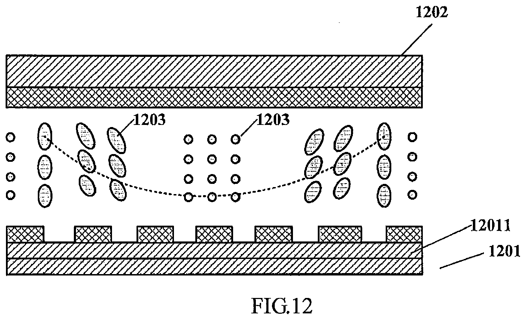

FIG. 12 is a schematic structural view of the liquid crystal panel provided by the embodiment of the present disclosure. The liquid crystal panel comprises a counter substrate (e.g. a color filter substrate) 1202 and an array substrate 1201, and an integrated chip 12011 is arranged on the array substrate 1201; and liquid crystal molecules 1203 are filled between the counter substrate 1202 and the array substrate 1201 to form a liquid crystal lens. When a color filter is provided on the array substrate 1201, the color filter may be not formed on the counter substrate 1202 again.

For instance, part or all of the devices from the group consisting of a CPU, an RAM, an FLASH, a DSP, a compression and encoding processor, and an image sensor may be integrated into the integrated chip 12011. An optical filter 21 and the image sensor 22 are arranged at the rear side of the liquid crystal lens 20 to filter imaging light incident from the liquid crystal lens 20 and acquire image signals.

For instance, the array substrate 1201 may be, but not limited to, a monocrystalline silicon array substrate, a low-temperature polysilicon array substrate or a high-temperature polysilicon array substrate and may be any substrate in which the peripheral integrated circuits have higher migration.

For instance, the effective refractive index of extraordinary light of the liquid crystal molecules 1203 filled between the counter substrate 1202 and the array substrate 1201 satisfies the following condition:

$$n_{e\,eff} = \frac{n_o n_e}{\sqrt{n_o^2 \cos^2 \theta + n_e^2 \sin^2 \theta}},$$

where $n_{e\,eff}$ refers to the effective refractive index of the extraordinary light of the liquid crystal molecules; $n_o$ refers to the refractive index of ordinary light of the liquid crystal molecules; $n_e$ refers to the refractive index of the extraordinary light of the liquid crystal molecules; and $\theta$ refers to the polar angle of the liquid crystal molecules.

The liquid crystal display panel, a backlight (not shown), and an integrated circuit board configured to provide control signals for the liquid crystal display panel can be combined to form the liquid-crystal display device. In the foregoing devices, except that the liquid crystal display panel is the liquid crystal display panel provided by an embodiment of the present disclosure, the structures of other parts may be the same as those of the traditional liquid crystal panel and will not be further described herein. The liquid-crystal display device may be applied to monitors, televisions, mobile phones, cameras and the like.

The method for integrating a camera on a liquid crystal display panel, the liquid crystal display panel and the liquid-crystal display device, provided by the embodiments of the present disclosure, can realize integrating of the camera in the liquid crystal display panel without occupying a frame area of the liquid crystal panel, by integrating the circuits configured to achieve the functions of a CPU, a RAM, an FLASH, a DSP, a compression and encoding processor, and an image sensor respectively on the integrated chip, arranging the integrated chip on the array substrate or directly forming the circuit for achieving the function of the integrated chip on the array substrate, and filling the liquid crystals between the color filter substrate and the array substrate to form the liquid crystal lens.

## Claims

1. A method for integrating a camera in a liquid crystal display panel, the liquid crystal display panel comprising an array substrate (110, 1201) and a counter substrate (120, 1202), the method comprising:

   arranging an integrated chip (12011) of the camera on the array substrate (1201) or directly forming circuits for achieving the function of the integrated chip (12011) on the array substrate (1201); and
   disposing a lens of the camera at a non-effective display area of the liquid crystal panel, and, thus, integrating the lens in a peripheral area (1002) of the liquid crystal display panel or in a partial space (1103) divided from an effective display area (1001; 1102) of the liquid crystal display panel;

**characterized by** filling liquid crystal molecules (1203) between the counter substrate (1202) and the array substrate (1201) to form as the lens of the camera a liquid crystal lens ; whereby
the liquid crystal lens of the camera is a planar liquid crystal lens;
and by arranging, to form the liquid crystal lens of the camera, a first electrode (111) on the array substrate (110, 1201) and a second electrode (121) on the counter substrate (120, 1202); wherein
the first electrode (111) and the second electrode (121) are provided to form an electric field between the first electrode (111) and the second electrode (121) for deflecting the liquid crystal molecules (1203) used for the liquid crystal lens; and wherein drive circuits for the first electrode (111) and the second electrode (121) are based on thin film transistor, TFT, drive circuits.

2. The method according to claim 1, wherein an image sensor, a signal processing and control device and a memory device are integrated into the integrated chip (12011);
circuits configured to achieve the functions of the signal processing and control device and the memory device are respectively formed on the same chip; and
circuits for achieving the function of the image sensor are integrated on the chip to form the integrated chip (12011).

3. The method according to claim 1 or 2, wherein liquid crystals (1203) are filled between the counter substrate (1202) and the array substrate (1201) with thin-film transistor liquid crystal display, TFT-LCD, technology to form the liquid crystal lens.

4. The method according to any one of claims 1 to 3, wherein the array substrate (1201) is a monocrystalline silicon array substrate, a low-temperature polysilicon array substrate or a high-temperature polysilicon array substrate.

5. A liquid crystal display panel, comprising a counter substrate (120, 1202), an array substrate (110, 1201) and an integrated camera, wherein the camera includes an integrated chip (12011) and a lens; wherein
the integrated chip (12011) of the camera is arranged on the array substrate (1201); and wherein the lens of the camera is disposed at a non-effective display area of the liquid crystal panel, and, thus, the lens is integrated in a peripheral area (1002) of the liquid crystal display panel or in a partial space (1103) divided from an effective display area (1001; 1102) of the liquid crystal display panel; **characterized in that**
liquid crystal molecules (1203) are filled between the counter substrate (1202) and the array substrate (1201) to form as the lens of the camera a liquid crystal lens; wherein
the liquid crystal lens of the camera is a planar liquid crystal lens; and wherein,
to form the liquid crystal lens of the camera, a first electrode (111) is arranged on the array substrate (110, 1201) and a second electrode (121) is arranged on the counter substrate (120, 1202); the first electrode (111) and the second electrode (121) are provided to form an electric field between the first electrode (111) and the second electrode (121) for deflecting the liquid crystal molecules (1203) used for the liquid crystal lens; and drive circuits for the first electrode (111) and the second electrode (121) are based on TFT drive circuits.

6. The liquid crystal panel according to claim 5, wherein the array substrate (1201) is a monocrystalline silicon array substrate, a low-temperature polysilicon array substrate or a high-temperature polysilicon array substrate.

7. The liquid crystal panel according to any one of claims 5 to 6, wherein an image sensor, a signal processing and control device and a memory device are integrated into the integrated chip (12011).

8. A liquid-crystal display device, comprising the liquid crystal display panel according to any one of claims 5 to 7.

**Patentansprüche**

1. Verfahren zum integrieren einer Kamera in ein Flüssigkristallanzeige-Panel, wobei das Flüssigkristallanzeige-Panel ein Array-Substrat (110, 1201) und ein Gegensubstrat (120, 1202) aufweist, wobei das Verfahren aufweist:

Anordnen eines integrierten Chips (1211) der Kamera auf dem Array-Substrat (1201) oder direktes Bilden von Schaltkreisen zum Erreichen der Funktion des integrierten Chips (1211) auf dem Array-Substrat (1201); und Anordnen einer Linse der Kamera auf einem unwirksamen Anzeigebereich des Flüssigkristall-Panels und so integrieren der Linse in einem peripheren Bereich (1002) des Flüssigkristallanzeige-Panels oder in einem Teilraum (1103), der von einem wirksamen Anzeigebereich (1001; 1102) des Flüssigkristallanzeige-Panels abgetrennt ist;

**gekennzeichnet durch**

Füllen von Flüssigkristallmolekülen (1203) zwischen das Gegensubstrat (1202) und das Array-Substrat (1201) um eine Flüssigkristalllinse als die Linse der Kamera zu bilden; wodurch die Flüssigkristalllinse der Kamera eine planare Flüssigkristalllinse ist; und

Anordnen, um die Flüssigkristalllinse der Kamera zu bilden, einer ersten Elektrode (111) auf dem Array-Substrat (110, 1201) und einer zweiten Elektrode (121) auf dem Gegensubstrat (120, 1202); wobei die erste Elektrode (111) und die zweite Elektrode (121) vorgesehen sind, um ein elektrisches Feld zwischen der ersten Elektrode (111) und der zweiten Elektrode (221) zum Ablenken der Flüssigkristallmoleküle (1203), die für die Flüssigkristalllinse verwendet werden, zu bilden; und wobei Treiberschaltungen für die erste Elektrode (111) und die zweite Elektrode (121) auf Dünnschichttransistor-, TFT-, Treiberschaltungen basieren.

2. Verfahren gemäß Anspruch 1, wobei
ein Bildsensor, eine Signalverarbeitungs- und Steuereinrichtung und eine Speichereinrichtung in den integrierten Chip (1211) integriert sind;
Schaltkreise, die konfiguriert sind, um die Funktion der Signalverarbeitungs- und Steuereinrichtung und der Speichereinrichtung zu erreichen, jeweils auf dem gleichen Chip ausgebildet sind; und
Schaltkreise zum Erreichen der Funktion des Bildsensors auf dem Chip integriert sind, um den integrierten Chip (1211) zu bilden.

3. Verfahren gemäß Anspruch 1 oder 2, wobei Flüssigkristalle (1203) zwischen das Gegensubstrat (1202) und das Array-Substrat (1201) mit der Dünnschichttransistorflüssigkristallanzeigen-, TFT-LCD-Technologie gefüllt sind, um die Flüssigkristalllinse zu bilden.

4. Verfahren gemäß einem der Ansprüche 1 bis 3, wobei das Array-Substrat (1201) ein monokristallines Silizium-Array-Substrat, ein Niedrigtemperaturpolysilizium-Array-Substrat oder ein Hochtemperaturpolysilizium-Array-Substrat ist.

5. Flüssigkristallanzeige-Panel mit einem Gegensubstrat (1020, 1202), einem Array-Substrat (110, 1201) und einer integrierten Kamera, wobei die Kamera einen integrierten Chip (1211) und eine Linse aufweist, wobei
der integrierte Chip (1211) der Kamera auf dem Array-Substrat (1201) angeordnet ist; und wobei die Linse der Kamera auf einem unwirksamen Anzeigebereich des Flüssigkristall-Panels angeordnet ist und so die Linse in einem peripheren Bereich (1002) des Flüssigkristallanzeige-Panels oder in einem Teilraum (1103), der von einem wirksamen Anzeigebereich (1001; 1102) des Flüssigkristallanzeige-Panels abgeteilt ist, integriert ist;
**gekennzeichnet dadurch, dass**
Flüssigkristallmoleküle (1203) zwischen das Gegensubstrat (1202) und das Array-Substrat (1201) gefüllt sind, um eine Flüssigkristalllinse als die Linse der Kamera zu bilden; wobei
die Flüssigkristalllinse der Kamera eine planare Flüssigkristalllinse ist; und wobei, um die Flüssigkristalllinse der Kamera zu bilden, eine erste Elektrode (111) auf dem Array-Substrat (110, 1201) angeordnet ist und eine zweite Elektrode (121) auf dem Gegensubstrat (120, 1202) angeordnet ist; die erste Elektrode (111) und die zweite Elektrode (121) vorgesehen sind, um ein elektrisches Feld zwischen der ersten Elektrode (111) und der zweiten Elektrode (121) zum Ablenken der Flüssigkristallmoleküle (1203), die für die Flüssigkristalllinse verwendet werden, zu bilden; und Treiberschaltungen für die erste Elektrode (111) und die zweite Elektrode (121) auf TFT-Treiberschaltungen basieren.

6. Flüssigkristall-Panel gemäß Anspruch 5, wobei das Array-Substrat (1201) ein monokristallines Silizium-Array-Substrat, ein Niedrigtemperatur-Polysilizium-Array-Substrat oder ein Hochtemperatur-Polysilizium-Array-Substrat ist.

7. Flüssigkristall-Panel gemäß einem der Ansprüche 5 bis 6, wobei ein Bildsensor, eine Signalverarbeitungs- und Steuereinrichtung und eine Speichereinrichtung in den integrierten Chip (1211) integriert sind.

8. Flüssigkristallanzeigevorrichtung mit dem Flüssigkristallanzeige-Panel gemäß einem der Ansprüche 5 bis 7.

**Revendications**

1. Procédé pour intégrer une caméra dans un panneau d'affichage à cristaux liquides, le panneau d'affichage à cristaux liquides comprenant un substrat de réseau (110, 1201) et un contre-substrat (120, 1202), le procédé comprenant :

l'agencement d'une puce intégrée (12011) de la caméra sur le substrat de réseau (1201) ou la formation directe de circuits pour réaliser la fonction de la puce intégrée (12011) sur le substrat de réseau (1201) ; et

la disposition d'une lentille de la caméra au niveau d'une zone d'affichage non effective du panneau d'affichage à cristaux liquides et ainsi, l'intégration de la lentille dans une zone périphérique (1002) du panneau d'affichage à cristaux liquides ou dans un espace partiel (1103) qui est divisé à partir d'une zone d'affichage effective (1001 ; 1102) du panneau d'affichage à cristaux liquides ;

**caractérisé par** :

le remplissage de molécules de cristaux liquides (1203) entre le contre-substrat (1202) et le substrat de réseau (1201) de manière à former, en tant que lentille de la caméra, une lentille à cristaux liquides ; d'où il résulte que : la lentille à cristaux liquides de la caméra est une lentille à cristaux liquides plane ; et par :

l'agencement, de manière à former la lentille à cristaux liquides de la caméra, d'une première électrode (111) sur le substrat de réseau (110, 1201) et d'une seconde électrode (121) sur le contre-substrat (120, 1202) ; dans lequel :

la première électrode (111) et la seconde électrode (121) sont constituées de manière à ce qu'elles forment un champ électrique entre la première électrode (111) et la seconde électrode (121) pour dévier les molécules de cristaux liquides (1203) qui sont utilisées pour la lentille à cristaux liquides ; et dans lequel :

des circuits de pilotage pour la première électrode (111) et pour la seconde électrode (121) sont basés sur des circuits de pilotage à transistor(s) à film mince, TFT.

2. Procédé selon la revendication 1, dans lequel :

un capteur d'image, un dispositif de traitement de signal et de commande ainsi qu'un dispositif de mémoire sont intégrés à l'intérieur de la puce intégrée (12011) ;

des circuits qui sont configurés pour réaliser les fonctions du dispositif de traitement de signal et de commande ainsi que du dispositif de mémoire sont respectivement formés sur la même puce ; et

des circuits pour réaliser la fonction du capteur d'image sont intégrés sur la puce de manière à former la puce intégrée (12011).

3. Procédé selon la revendication 1 ou 2, dans lequel des cristaux liquides (1203) sont remplis entre le contre-substrat (1202) et le substrat de réseau (1201) à l'aide d'une technologie affichage à cristaux liquides à transistor(s) à film mince, TFT-LCD, pour former la lentille à cristaux liquides.

4. Procédé selon l'une quelconque des revendications 1 à 3, dans lequel le substrat de réseau (1201) est un substrat de réseau en silicium monocristallin, un substrat de réseau en polysilicium basse température ou un substrat de réseau en polysilicium haute température.

5. Panneau d'affichage à cristaux liquides, comprenant un contre-substrat (120, 1202), un substrat de réseau (110, 1201) et une caméra intégrée, dans lequel la caméra inclut une puce intégrée (12011) et une lentille ; dans lequel : la puce intégrée (12011) de la caméra est agencée sur le substrat de réseau (1201) ; et dans lequel :

la lentille de la caméra est disposée au niveau d'une zone d'affichage non effective du panneau d'affichage à cristaux liquides et ainsi, la lentille est intégrée dans une zone périphérique (1002) du panneau d'affichage à cristaux liquides ou dans un espace partiel (1103) qui est divisé à partir d'une zone d'affichage effective (1001 ; 1102) du panneau d'affichage à cristaux liquides ;

**caractérisé en ce que** :

des molécules de cristaux liquides (1203) sont remplies entre le contre-substrat (1202) et le substrat de réseau (1201) de manière à former, en tant que lentille de la caméra, une lentille à cristaux liquides ; dans lequel : la lentille à cristaux liquides de la caméra est une lentille à cristaux liquides plane ; et dans lequel :

pour former la lentille à cristaux liquides de la caméra, une première électrode (111) est agencée sur le substrat de réseau (110, 1201) et une seconde électrode (121) est agencée sur le contre-substrat (120, 1202) ;

la première électrode (111) et la seconde électrode (121) sont constituées de manière à ce qu'elles forment un champ électrique entre la première électrode (111) et la seconde électrode (121) pour dévier les molécules de cristaux liquides (1203) qui sont utilisées pour la lentille à cristaux liquides ; et

des circuits de pilotage pour la première électrode (111) et pour la seconde électrode (121) sont basés sur des circuits de pilotage à TFT.

**6.** Panneau d'affichage à cristaux liquides selon la revendication 5, dans lequel le substrat de réseau (1201) est un substrat de réseau en silicium monocristallin, un substrat de réseau en polysilicium basse température ou un substrat de réseau en polysilicium haute température.

**7.** Panneau d'affichage à cristaux liquides selon l'une quelconque des revendications 5 et 6, dans lequel un capteur d'image, un dispositif de traitement de signal et de commande ainsi qu'un dispositif de mémoire sont intégrés à l'intérieur de la puce intégrée (12011).

**8.** Dispositif d'affichage à cristaux liquides comprenant le panneau d'affichage à cristaux liquides selon l'une quelconque des revendications 5 à 7.

FIG.1

arranging an integrated chip of the camera on the array substrate or directly forming circuits for achieving the function of the integrated chip on the array substrate — S201

filling liquid crystal molecules between the counter substrate and the array substrate to form a liquid crystal lens of the camera — S202

FIG.2

FIG.3

FIG.4

FIG.5

FIG.6

FIG.7

FIG.8

FIG.9

FIG.10

1101

1103

1102

FIG.11a

1101

1102

1103

FIG.11b

1101

1103

1102

FIG.11c

1101

1102

1103

FIG.11d

1202

1203    1203

12011

1201

FIG.12

**EP 2 720 084 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 8505466 A1
- US 20040212555 A1